# EUROPEAN PATENT APPLICATION

(11) **EP 1 760 631 A1**
(43) Date of publication of application: **07.03.2007**
(21) Application number: 05425620.1
(22) Date of filing: 05.09.2005
(51) Int. Cl.: G06K 7/10, G02B 26/12

(54) **Scanning device for an optical code reader**

(71) Applicant: DATALOGIC S.P.A., 40012 Lippo di Calderara di Reno (Bologna) (IT)
(72) Inventor: Ciabattoni, Stefano, 40137 Bologna (IT)
(74) Representative: Bottero, Claudio

(57) **Abstract**

A scanning device (40) for an optical code reader (1) is described, comprising an electric motor (42) having a stator (44), a magnetic rotor (43) and at least one coil (64), and a polygonal mirror (41) integral with the rotor (43) of the motor (42), characterized in that said at least one coil (64) is at least partially embedded in a printed circuit board (2) carrying the electronics for driving the motor (42).

## Description

The present invention concerns a scanning device for an optical code reader, in particular a barcode reader, as well as a scanning section and an optical code reader containing it.

As known, in an optical code reader, in particular a black and white or colour barcode and stacked code reader, a beam of collimated light (not necessarily in the visible range), like for example a laser light beam or the beam of an uncollimated light source, collimated through suitable collimating optics, is moved in a plane, called scanning plane, so as to form a scanning line that crosses the optical code. The light diffused by the optical code when it is illuminated by the scanning line is detected by a photodetector device, which transforms it into a time-variable electrical signal, which intensity represents the elements of the optical code, for example the bars and the spaces in the case of barcodes.

For the movement of the beam of collimated light to form the scanning line a scanning device is typically used comprising a rotary motor that drives a rotary polygonal mirror into rotation, in other words a polyhedron with polygonal base the faces of which side surface are mirrorly reflective. The collimated light beam, directed towards the polygonal mirror in a non-radial direction, is deflected by a face thereof and, because of the rotation of the mirror, sweeps a certain angle in a plane, called scanning plane. At the corner between one face and the adjacent one, the collimated light beam starts to sweep the same angle again. On the plane of the optical code, the spot of collimated light therefore crosses, in conditions of perfect alignment, a same scanning line in a rapid succession of times.

Miniaturized optical codes readers are increasingly required, for example for applications in which the optical code reader is a component of complex automatic systems, such as automatic machines, where it is essential for all of the components to have the minimum possible bulk.

In miniaturized optical code readers a non retroreflective configuration is typically used, wherein the scanning device and in particular its mirror faces are not used to collect the light diffused by the optical code and therefore can have a size of an order of magnitude of the size of the laser spot incident on each face.

EP 1 207 489 A2 describes a scanning device for an optical code reader comprising a flat electric motor, comprising a substantially hollow disc-shaped stator, which houses windings and a magnetic rotor coaxially inner to the windings and supported by a drive shaft, projecting from the stator. A polygonal mirror is integrally attached to the projecting portion of the drive shaft outside the stator. The motor-polygonal mirror assembly is housed in a dedicated casing, to which the ends of the drive shaft are fixed.

Although the scanning device of such a document has a notably small size, it is an independent component, which casing must be assembled in the reader, through cables and fastening points typically by welding.

EP 1 115 022 A2 discloses a scanning device for an optical code reader comprising an electric motor having a tube shaped stator with a coaxially outer coil and a shaft rotating inside bearings of the stator, which supports a polygonal mirror and a magnet fixed inside the polygonal mirror, externally or on top coaxial with the coil, wherein the stator is fixed to the printed circuit board with the coil resting upon the printed circuit board and electrically connected to the driving circuit.

Even if there is no casing of the motor, the size of the polygonal mirror, and therefore of the scanning device, must in any case take the bulk of the coil into account.

The technical problem at the basis of the present invention is to provide a scanning device for an optical code reader whose bulk in the reader is particularly small.

In a first aspect thereof, the invention concerns a scanning device for an optical code reader, comprising an electric motor having a stator, a magnetic rotor and at least one coil, and a polygonal mirror integral with the rotor of the motor, characterized in that said at least one coil is at least partially embedded in a printed circuit board (PCB) carrying the electronics for driving the motor.

Through such a provision, the bulk of the scanning device is reduced since the coil(s) project(s) at most partially from the PCB. Moreover, there is no casing for containing the motor. The motor "grows" directly on the PCB, of which it forms an integral part. The connection of the motor to the electronics is therefore simplified, cables and weldings being avoided. During its integration in an optical code reader, the scanning device can be easily manipulated through the printed circuit board.

Preferably, said at least one coil is formed directly in the PCB, even more preferably by deposition.

Alternatively, said at least one coil is housed in a respective recess formed in the PCB. In such a case, preferably said at least one coil is preformed.

In order to improve the uniformity of rotation of the rotor of the motor a plurality of coils are preferably comprised.

According to a provision that is particularly innovative even by itself, irrespective of the fact that the coils are at least partially embedded in the PCB, the motor of the scanning device comprises a pair of rolling bearings for rotation of the magnetic rotor about the stator, which are arranged on opposite sides with respect to the polygonal mirror.

In such a way, the problem of the run-out of the rotor of the motors of the prior art is advantageously reduced, which - as better explained later on with reference to the figures - consists of the fact that, because of clearances in the bearings, the rotor not only carries out a motion of pure rotation, rather also a precession motion. In the application to the scanning of a beam of collimated light, such a precession motion in turn causes the so-called raster effect: instead of generating a single scanning line repeated at high speed as the scanning device and therefore the polygonal mirror rotate, a series of scanning lines parallel to each other is generated.

It must be highlighted that the uncontrolled and undesired raster effect described above should not be confused with the raster-type scanner pattern that is deliberately generated in a controlled manner in some optical code readers for reading stacked codes or for a reading based upon reconstruction techniques of codes randomly oriented with respect to the reader.

Actually, such a raster-type pattern can advantageously also be provided in the scanning device of the present invention, should the polygonal mirror have faces with different inclination with respect to its rotation axis.

According to another provision that is particularly advantageous also by itself, the stator of the motor can be radially outside the rotor carrying the polygonal mirror, the stator having a window for entry and exit of the collimated light.

In such a way, the stator forms a cage that protects the polygonal mirror from shocks, contact with electrical cables and dirt that could compromise its mirror treatment, in particular avoiding contact with the fingers during assembly or maintenance of the reader. Moreover, said cage is particularly suitable for supporting the two bearings at opposite ends of the polygonal mirror.

Preferably, the stator of the motor comprises an annular wall for attachment onto the printed circuit board and a wall held thereby substantially parallel to the printed circuit board, said walls forming with the printed circuit board a recess for housing a magnet of the rotor in a position facing said at least one coil.

The motor is preferably of the rotary shaft type, but it could be of the fixed shaft type.

In a second aspect thereof, the invention concerns a scanning section of an optical code reader, comprising a scanning device as described above and an emitter of a reading light beam.

The beam emitter is typically a laser emitter.

In case however the light beam emitted by the emitter is not collimated, like for example in case of an LED source, the scanning section can further comprise a collimating optics of the reading light beam.

In a third aspect thereof, the invention concerns an optical code reader comprising a scanning device as described above.

The invention shall be better described hereafter with reference to a preferred embodiment, based on the attached drawings, wherein corresponding elements are designated by similar numbers. In the drawings:
- Fig. 1 illustrates a miniaturized optical code reader according to the invention, in a partially assembled state,
- Fig. 2 illustrates the reader of Fig. 1 in an assembled state,
- Fig. 3 illustrates the reader of Fig. 1 in an assembled state and with protective casing,
- Fig. 4 illustrates an exploded perspective view of a scanning section of the reader of Fig. 1,
- Figs. 5 and 6 illustrate an embodiment of a scanning device according to the invention, respectively in perspective and in sectional view,
- Figs. 7 and 8 schematically illustrate the problem of the run-out of a motor,
- Fig. 9 schematically illustrates the raster effect, and
- Fig. 10 schematically illustrates the position of the center of mass of a conventional motor.

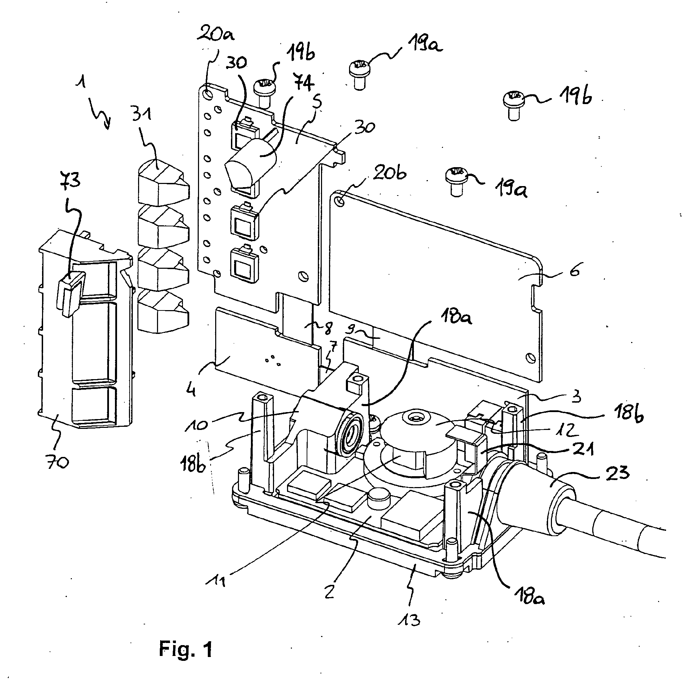

In figures 1-3 a miniaturized optical code reader 1 is illustrated, of a size 40mm x 30mm x 22mm (volume of about 27cm³).

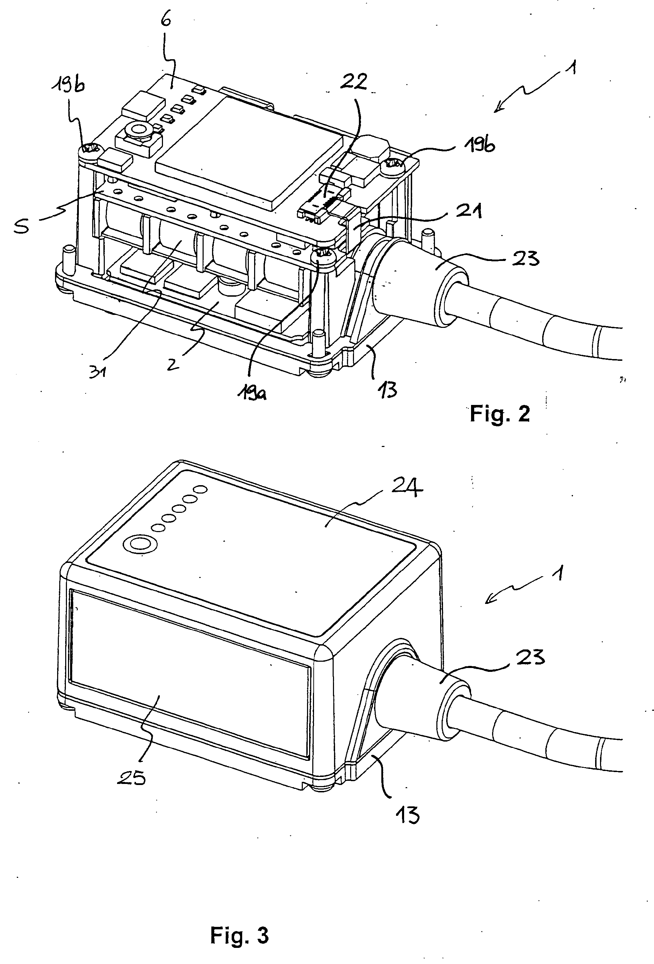

The reader 1 comprises a first PCB 2 and a second PCB of the rigid/flexible type, made up of four rigid portions or circuits 3, 4, 5, 6 connected together by three flexible connections 7, 8, 9 that allow the PCB to be bent so that the circuits 3, 4, 5, 6 are arranged at an angle (figure 2) and form, with the first PCB 2, four of the six faces of a rectangular parallelepiped.

On the first PCB 2 a device for scanning the laser beam emitted by a laser emitter 10 is formed. The scanning device, better described hereafter, comprises a polygonal mirror 11 driven into rotation by a motor 12 and the electronics for driving the motor 12.

The rotary polygonal mirror 11 can have the faces with different inclinations for reading stacked codes.

The back circuit 3 of the second PCB is the input/output circuit (I/O) of the reader 1. Back, like other terms hereafter, is used merely to ease the description and with reference to the orientation of figures 1-3. The back circuit 3 of the second PCB is connected, through the flexible connection 7, to the circuit 4 of the second PCB, on the side in the assembled reader 1.

The side circuit 4 is the driving circuit of the laser emitter 8. The side circuit 4 of the second PCB is in turn connected, through the flexible connection 8, with the third circuit 5 of the second PCB, on the top and inner in the assembled reader 1 (figure 2).

On the top inner circuit 5 of the second PCB a receiving section is made, not better described hereafter, comprising a plurality of photodetector devices 30, in particular photodiodes, a corresponding plurality of optical receiving devices 31 and the electronics (not shown) for driving the photodetecting devices 30 and possibly for pre-processing the signal emitted by them.

The back circuit I/O 3 of the second PCB is further connected, through the flexible connection 9, to the circuit 6 carrying the reading and/or decoding electronics, which in the assembled reader 1 is on the top and outer (figure 2).

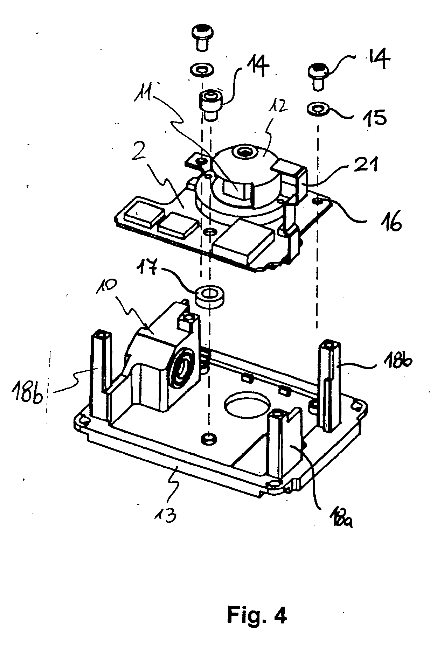

As can be seen more clearly in figure 4, the first PCB 2 is fixed to a support base 13 through screws 14 and washers 15 passing in respective holes 16 of the PCB 2. At one of the screws, the front one in figure 4, an elastic ring 17 is placed between the PCB 2 and the support base 13.

When, like in the illustrated embodiment, the laser emitter 10 is fixed to the support base 13 and not to the PCB 2, the elastic ring 17, by adjusting the degree of tightness of the screw 14, allows the inclination of the PCB 2 to be adjusted with respect to the emission plane of the laser beam by the emitter 10, thus allowing an optimal alignment between the rotary polygonal mirror 11 and the scanning laser ray, and between the emission plane of the laser beam and the line of view of the receiving optics formed on the top inner circuit 5 of the second PCB.

Moreover, the elastic ring 17 elastically deforms under the tightening action of the screw 14 and allows possible vibrations transmitted to the PBC 2 from the support base 13 to be absorbed at least in part.

Analogous elastic rings can also be provided at the other screws 14.

The support base 13 is provided, in proximity to the four corners, with four posts 18a, 18b. More specifically, the two posts 18a arranged according to a diagonal of the support base 13 are of a lower height than the two posts 18b arranged according to the other diagonal of the support base 13. The top inner circuit 5 of the second PCB rests upon the posts 18a of lower height and is fixed there through screws 19a passing in holes 20a of the receiving circuit 5. The top outer circuit 6 of the second PCB rests upon the posts 18b of greater height and is fixed there through screws 19b passing in holes 20b of the receiving circuit 5.

The first PCB 2 is connected to the second PCB, and in particular to its top outer circuit 6, through a flat flexible cable (FFC) 21 that engages in suitable connectors, the connector 22 provided on the top outer circuit 6 of the second PCB being visible in figure 2, while the connector provided on the first PCB 2 cannot be seen since it is on the bottom side thereof.

A cable 23 for supplying power and for signal input/output is connected to the support base 13.

Figure 3 illustrates a cover 24 that couples on the support base 13 to form a protective casing of the reader 1. The cover 24 is provided with an emission/receiver window 25 that, in the mounted state of the reader 1, faces the receiving section and the emitting and scanning section, to allow output of the laser light emitted by the emitter 10 and scanned by the rotary polygonal mirror 11 and input of the light diffused by the optical code when illuminated by such scanned laser light. The emission/receiver window 25 can also incorporate or comprise a high-pass optical filter (i.e. that allows light with great wavelengths to pass) or low-pass optical filter for rejecting the ambient light, for example having a pass band of 580-700 nm. In an alternative embodiment, the casing consisting of the base 13 and the cover 24 can be missing, the first PCB 2 of the reader 1 in such a case being fixed directly in any apparatus, preferably with the interposition of the elastic ring 17 as described above for protection against shocks and vibrations. In case the casing is not provided, the laser emitter 10 and the posts 18a, 18b are directly fixed onto the first PCB 2 and the emission/receiver window 25, as well as the possible filter, are fixed, for example by gluing, between the first PCB 2 and the top inner circuit 5 of the second PCB. It should be understood that a filter thus fixed between the first PCB 2 and the top inner circuit 5 can also be provided in case of use of the casing 13, 24, as an alternative to its arrangement at the emission/receiver window 25.

Making the reader 1 through the two PCBs one of which can be bent as described above is advantageous since in the unassembled state the reader 1 can be laid flat and easily protected, packaged, stored and sent. The flexible connections 7, 8, 9, also allow a particularly compact arrangement of the electronics around the optics of the reader 1.

It should be understood that a single PCB could also be provided, on which the scanning circuit is also made, connected through a flexible connection to the back circuit 3 or to the side circuit 4.

As shall be manifest to those skilled in the art, the illustrated reader 1 is of the non-retroreflective type, the optimal configuration for miniaturized readers since it allows the size of the optical scanning device (the polygonal mirror 11 in the illustrated embodiment) to be minimized reducing it to the order of magnitude of the size of the laser spot incident on each face.

More specifically, the size of each face of the polygonal mirror 11 is typically about three times the width of the laser spot incident on it in the direction perpendicular to the rotation axis of the polygonal mirror 11, and it is about twice the width of the laser spot in the direction of the rotation axis.

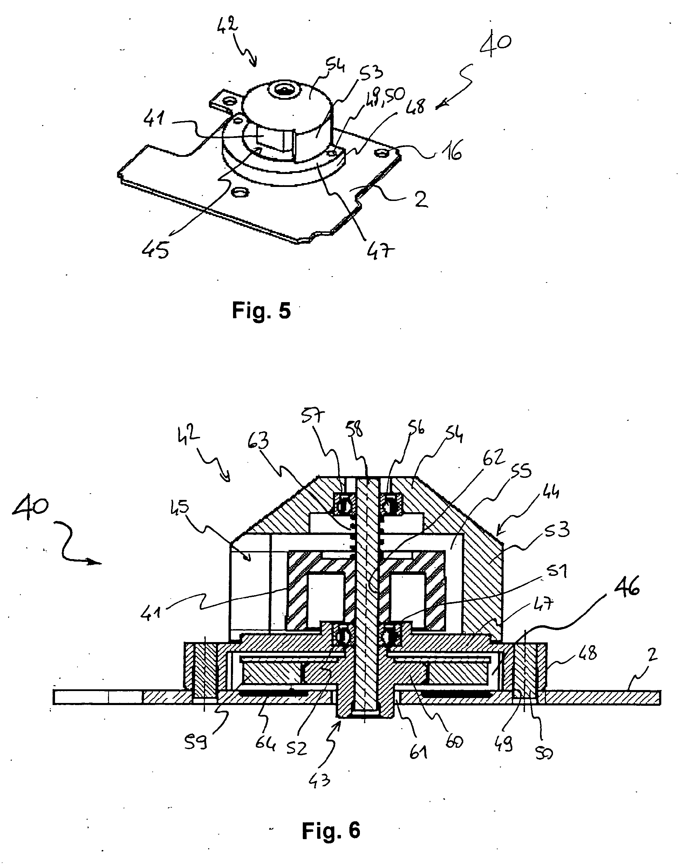

In figures 5 and 6 an embodiment of a scanning device 40 is illustrated, in perspective and in sectional view respectively.

The scanning device 40 comprises an electric motor with mobile shaft, indicated there with reference numeral 42 and a polygonal mirror, indicated there with reference numeral 41, integral with a rotor 43 of the motor 42. A stator 44 of the motor is fixed to the first PCB 2 and is radially outside the rotor 43, in the form of a cage provided with a side window 45 for input of collimated light and output of collimated light deflected by the faces of the polygonal mirror 41.

In more detail, inside the cage-shaped stator 44, on the side of the PCB 2 a recess 46 is formed by a wall 47 of the stator 44, parallel to the PCB 2 and spaced from it through an annular wall 48 of the stator 44, provided with holes 49 to receive screws 50 for fastening the stator 44 to the PCB 2.

The wall 47 of the stator parallel to the PCB 2 is provided with a central hole 51 to which the outer ring of a first ball bearing 52 is integrally attached.

On the other side of the wall 47, a side wall 53 extending along a sector of circumference and a dome-shaped wall 54 held thereby substantially parallel to the PCB 2 form an inner housing 55 and said opening 45. In the dome-shaped wall 54 a central hole 56 is formed to which the outer ring of a second ball bearing 57 is integrally attached.

Between the two ball bearings 52, 57 a shaft 58 is rotatably supported, integrally attached to a magnet 59 of the rotor 43 through a hub 60. The hub 60 is shown projecting into a hole 61 of the PCB 2. The magnet 59 extends into the recess 46 of the stator 44 formed adjacent to the PCB 2, facing the PCB.

In the housing 55 on the other side of the wall 47, the polygonal mirror 41 is fit around the shaft 58, which extends in a hole 62 of the polygonal mirror 41 and in the inner rings of the bearings 52, 57. The polygonal mirror 41 is coupled to the shaft 58 with slight interference and it is preferably locked onto it through gluing.

A compression spring 63 extending around the shaft 58 between the polygonal mirror 41 and the second bearing 57 maintains the position of the rotor 43 and of the polygonal mirror 41 and ensures the preloading on the bearings 52, 57 for recovering the internal clearances.

Directly in the PCB 2 a plurality of coils 64 are formed, for example by deposition, the excitation of which is controlled by the electronics for driving the motor (not shown) formed on the PCB 2 itself. The coils 64 are distributed around the hole 61 for receiving the shaft 58 so that the magnet 59 faces them.

The special construction of the scanning device 40 described above is advantageous from the following different points of view.

The polygonal mirror 41 is protected by the cage-shaped stator 44 from shocks, contact with parts inside the reader (for example electrical cables) and dirt that could compromise the functionality of the motor and/or damage the mirror treatment, avoiding in particular contact with fingers during the assembly or maintenance of the reader 1.

The excitation coils 64, being formed directly on the PCB 2, do not add to the bulk of the scanning device 40.

Moreover, their deposition directly on the PCB 2 makes it pointless to provide a casing of the motor and connection cables with the driving electronics, the entire motor becoming an integral part of the PCB 2. In the assembly step of the reader 1, it is not necessary to directly manipulate the motor and the associated polygonal mirror 41, what would be difficult due to the miniaturized size, instead it being possible to grip the PCB 2. Welding points and an additional assembly step are also avoided, since the motor 42 is assembled directly onto the PCB 2.

In case the emitter of collimated light, for example the laser emitter 10, is formed on the PCB 2 itself, the alignment of the light beam with the polygonal mirror 41 is easied.

As stated in the introductory part, moreover, the provision of the two bearings 52, 57 on the two sides of the polygonal mirror 41 significantly reduces the problem of run-out of the rotor and the consequent undesired raster effect.

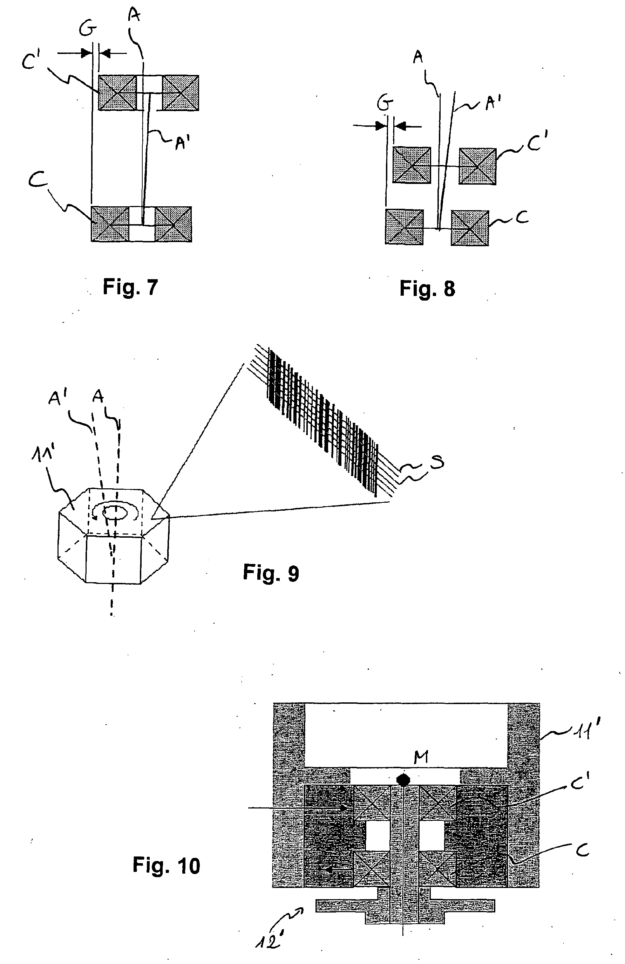

With reference to figures 7 and 8, in case of imperfections in the alignment of the bearings C and C' for supporting the shaft of the motor and of a consequent clearance G at the bearings, the rotor of the motor and therefore the polygonal mirror do not only carry out a pure rotation motion about the axis A of the shaft, but they also carry out a precession motion, wherein the axis of the rotor (the drive shaft in case of motors with rotary shaft) describes a cone, whose generatrix is indicated with A', or a more complex figure in case of clearances at both bearings C, C'. The scanning beam, therefore, no longer generates a single scanning line repeated at high speed as the polygonal mirror 11' rotates, but a series of scanning lines S parallel to each other, as shown in figure 9.

This effect is undesired, also in the case of a polygonal mirror 11' with faces having different inclinations to purposely generate a raster-type scanning pattern, since the displacement of the scanning line in a direction perpendicular to the scanning direction caused by run-out, although apparently analogous, is uncontrolled. Moreover, such an effect could self enhance, since the rotation out of axis (run-out) of the rotor stresses the bearings C, C' further, with the risk of increasing their wear and therefore their clearance G, notwithstanding the rotating masses are extremely small.

From a comparison between figures 7 and 8 it should also be noted that the undesired run-out is, the clearance G of the bearings being equal, more intense if the bearings C, C' are less spaced apart (figure 8), since the angle between the theoretical rotation axis A and the actual rotation axis A' increases.

The application of the two bearings 52, 57 on the two sides of the polygonal mirror 41 in the scanning device 40 allows them to be kept a suitable distance apart, without increasing the size of the motor 42.

The aforementioned arrangement of the bearings 52, 57 also causes less wear thereof, since the center of mass M of the rotating mass consisting of rotor 43 and polygonal mirror 41 falls in an intermediate position between the bearings 52, 57, and not in proximity of the upper bearing C' as occurs in the case of a flat motor with polygonal mirror extending also above the motor 12', as shown schematically in figure 10, or above the motor only.

As an alternative to the provision of a plurality of coils 64, it is possible to provide for a single coil concentric with the hole 61 for receiving the shaft 58.

Moreover, as an alternative to the coil or coils 64 formed directly in the PCB 2, it is possible to provide that the coil(s) be housed in one or more recesses formed in the PCB, on the side of the motor 42 and in particular of the magnet 59, so that they are at least partially embedded in the PCB 2 and therefore project at most partially from the PCB 2.

The coil(s) are in such a case preferably preformed and rested or glued in the respective recess of the PCB 2.

The above teachings can of course also be applied in case of a motor with fixed shaft, the necessary changes being fully within the capability of those skilled in the art.

Although the scanning device 40 has been described with reference to the miniaturized optical code reader of Figures 1-3, it should be understood that it can advantageously be used in optical code readers of other types and configuration.

On the other hand, it should be understood that the preferred embodiment of reader described above has other per se innovative aspects, including its configuration through two PCBs one of which can be bent and its ability to be fixed with alignment adjustment through elastic rings.

It should be understood that by the reader 1 of the invention it is possible to read linear codes, in particular barcodes and stacked codes (for example PDF 417), but also two-dimensional codes, including characters, providing a second scanning mechanism in the direction perpendicular to the scanning line to form a raster of scanning lines, for example a different inclination of the faces of the polygonal mirror 11, a second oscillating mirror or a relative movement between reader 1 and optical code, like for example in the case of optical codes carried by objects in movement on a conveyor belt, since the extension of the raster pattern in any case falls within the field of view of the optical receiving devices 31.

## Claims

1. Scanning device (40) for an optical code reader (1), comprising an electric motor (42) having a stator (44), a magnetic rotor (43) and at least one coil (64), and a polygonal mirror (41) integral with the rotor (43) of the motor (42), **characterized in that** said at least one coil (64) is at least partially embedded in a printed circuit board (2) carrying the electronics for driving the motor (42).

2. Scanning device (70) according to claim 1,
**characterized in that** said at least one coil (64) is formed directly in the printed circuit board (2).

3. Scanning device (70) according to claim 2,
**characterized in that** said at least one coil (64) is formed by deposition.

4. Scanning device (70) according to any of the previous claims, **characterized in that** it comprises a plurality of coils (64).

5. Scanning device (40) according to any of the previous claims, **characterized in that** the motor (42) comprises a pair of rolling bearings (52, 57) for rotation of the magnetic rotor (43) about the stator (44), that are arranged on opposite sides with respect to the polygonal mirror (41).

6. Scanning device (40) according to any of the previous claims, **characterized in that** the stator (44) of the motor (42) is radially outside the rotor (43) carrying the polygonal mirror (41), the stator (44) having a window (45) for input and output of collimated light.

7. Scanning device (40) according to any of the previous claims, **characterized in that** the stator (44) of the motor (42) comprises an annular wall (48) for attachment onto the printed circuit board (2) and a wall (47) held thereby substantially parallel to the printed circuit board (2), said walls (47, 48) forming with the printed circuit board (2) a recess (46) for housing a magnet (59) of the rotor (43) in a position facing said at least one coil (64).

8. Scanning device (40) according to any of the previous claims, **characterized in that** the motor (42) is of the rotary shaft (58) type.

9. Scanning device (40) according to any of the previous claims, **characterized in that** the polygonal mirror (41) has faces with different inclination with respect to its rotation axis.

10. Scanning section of an optical code reader (1), comprising a scanning device (40) according to any of claims 1-9 and an emitter (10) of a reading light beam.

11. Optical code reader (1) comprising a scanning device (40) according to any of claims 1-9.
